# EUROPÄISCHE PATENTSCHRIFT

(11) **EP 3 438 691 B1**
(45) Veröffentlichungstag und Bekanntmachung des Hinweises auf die Patenterteilung: **14.07.2021**
(21) Anmeldenummer: 18184422.6
(22) Anmeldetag: 19.07.2018
(51) Int. Cl.: G01S 7/481, G01S 17/04, G01S 17/42, G01S 17/48

(54) **OPTOELEKTRONISCHER SENSOR UND VERFAHREN ZUM ERFASSEN VON OBJEKTEN IN EINEM ÜBERWACHUNGSBEREICH**
OPTOELECTRONIC SENSOR AND METHOD FOR DETECTING OBJECTS IN A SURVEILLANCE AREA
CAPTEUR OPTOELECTRONIQUE ET PROCÉDÉ DE DÉTECTION D'OBJETS DANS UNE ZONE DE SURVEILLANCE

(30) Priorität: 04.08.2017 DE 102017117694
(43) Veröffentlichungstag der Anmeldung: 06.02.2019
(73) Patentinhaber: SICK AG, 79183 Waldkirch (DE)
(72) Erfinder: Gimpel, Hartmut, 79194 Gundelfingen (DE); Tschuch, Sebastian, 79104 Freiburg (DE)

(56) Entgegenhaltungen:
- EP-A2- 2 560 366
- EP-B1- 1 031 471
- DE-A1- 19 514 626
- DE-A1-102007 004 609
- US-A1- 2016 182 891
- US-A1- 2017 115 497

## Beschreibung

Die Erfindung betrifft einen optoelektronischen Sensor und ein Verfahren zum Erfassen von Objekten in einem Überwachungsbereich nach dem Oberbegriff von Anspruch 1 beziehungsweise 12.

Viele optoelektronische Sensoren arbeiten nach dem Tastprinzip, bei dem ein Lichtstrahl in den Überwachungsbereich ausgesandt und der von Objekten zurückgeworfene Lichtstrahl wieder empfangen wird, um dann das Empfangssignal elektronisch auszuwerten. Dabei wird oft die Lichtlaufzeit (ToF, Time of Flight) mit einem bekannten Phasen- oder Pulsverfahren gemessen, um den Abstand eines angetasteten Objekts zu bestimmen. In einem beispielsweise aus der EP 2 469 296 B1 bekannten Pulsmittelungsverfahren werden für eine Messung eine Vielzahl von Einzelpulsen ausgesandt und die Empfangspulse statistisch ausgewertet. Eine andere Möglichkeit zur Bestimmung von Abständen ist die Triangulation. Hierbei sind Lichtsender und ein ortsauflösender Lichtempfänger nebeneinander angeordnet, und es wird die Position des Empfangslichtflecks in Abhängigkeit von dem Objektabstand ausgewertet.

Um den Messbereich zu erweitern, kann der Abtaststrahl bewegt werden, wie dies in einem Laserscanner geschieht. Dort überstreicht ein von einem Laser erzeugter Lichtstrahl mit Hilfe einer Ablenkeinheit periodisch den Überwachungsbereich. Zusätzlich zu der gemessenen Abstandsinformation wird aus der Winkelstellung der Ablenkeinheit auf die Winkellage des Objektes geschlossen, und damit ist der Ort eines Objektes in dem Überwachungsbereich in zweidimensionalen Polarkoordinaten erfasst. In vielen Laserscannern wird die Abtastbewegung durch einen Drehspiegel erreicht. Es ist aber auch bekannt, stattdessen den gesamten Messkopf mit Lichtsendern und Lichtempfängern rotieren zu lassen, wie dies beispielsweise in DE 197 57 849 B4 beschrieben ist.

Als Lichtquelle eines optoelektronischen Sensors dienen LEDs oder Laserdioden. Obwohl bei einem Lichttaster an sich nur ein Lichtstrahl und damit eine einzige Lichtquelle gebraucht wird, ist auch bekannt, ein Lichtbündel aus einem Array mit mehreren Lichtquellen zu nutzen. Ein Grund kann der Wunsch nach höherer optischer Ausgangsleistung sein.

Gerade VCSEL (Vertical Cavity Surface-Emitting Lasers) weisen häufig nicht mehr nur eine einzige Lichtemissionsfläche ("Mesa") auf, sondern mehrere, in direkter Nachbarschaft angeordnete Lichtemissionsflächen. Der Grund liegt darin, dass der Emissionswinkel von Licht aus kleinen Lichtemissionsflächen herstellerseitig besser kontrolliert werden kann.

Dann ist zwar die einzelne Lichtemissionsfläche kleiner, aber ein alle Lichtemissionsflächen umfassender Umkreis wird größer. Wird das Licht einer solchen VCSEL mit einer einzelnen Sendelinse abgebildet, ergeben sich daraus nachteilige größere Lichtflecken im Überwachungsbereich und letztlich auf dem Empfangselement des Sensors.

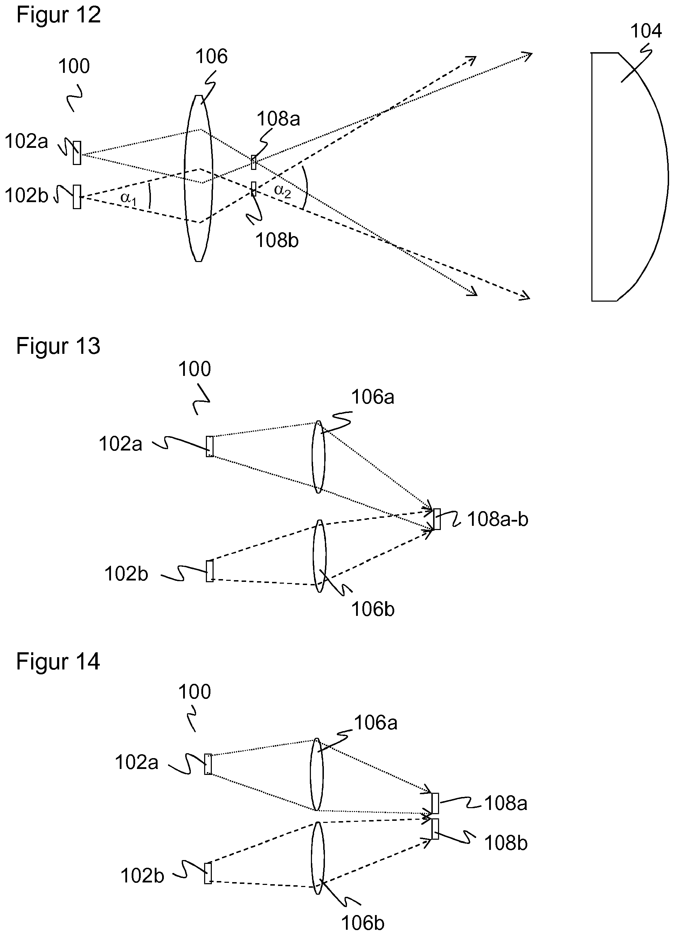

Mit einer einfachen Zusatzlinse lässt sich dieses Problem nicht lösen. Figur 12 zeigt einen beispielhaften Lichtsender 100 mit zwei Einzellichtquellen 102a-b und eine zugeordnete gemeinsame Sendeoptik 104. Eine zusätzliche Einzellinse 106 ist zwischen Lichtsender 100 und Sendeoptik 104 angeordnet. Sie erzeugt ein kleineres reelles Zwischenbild 108a-b der Einzellichtquellen 102a-b, so dass zunächst wie gewünscht der Umkreis um die Einzellichtquellen 102a-b kleiner geworden ist. Da aber die Etendue eine Erhaltungsgröße ist, muss das kleinere Zwischenbild 108a-b zwangsläufig mit einem vergrößerten Abstrahlwinkel ∝₂>∝₁ einhergehen. Deshalb wird insgesamt kein Vorteil erzielt, denn es trifft nicht mehr alles Licht die gemeinsame Sendeoptik 104.

Ein weiterer denkbarer Ansatz ist, der VCSEL ein Mikrolinsenfeld zuzuordnen, das für jede Lichtemissionsfläche einen zumindest teilweise getrennten Lichtpfad aufweist. Insbesondere wird mit jeweils einer Mikrolinse ein reelles Zwischenbild einer zugeordneten Lichtemissionsfläche erzeugt.

Figur 13 zeigt ein erstes Beispiel. Hier sind den beiden Einzellichtquellen 102a-b des Lichtsenders 100 jeweils Mikrolinsen 106a-b zugeordnet. Die nachgeordnete gemeinsame Sendeoptik 104 ist hier nicht mehr gezeigt. Jede Einzellichtquelle 102a-b wird von der zugeordneten Mikrolinse 106a-b auf dasselbe Zwischenbild 108a-b abgebildet, wobei der Überlapp nicht perfekt sein muss und das gemeinsame Zwischenbild 108a-b gegebenenfalls größer ist als eine Einzellichtquelle 102a-b. Hierbei kann zwar erreicht werden, dass der Divergenzwinkel der Einzellichtquellen konstant bleibt, doch durch die Verkippung der Hauptstrahlen der Einzellichtbündel ist der Divergenzwinkel des Gesamtlichtbündels weiterhin vergrößert. Ein zusätzlicher Nachteil des Ansatzes mit reellen Zwischenbildern kann in der nötigen großen Brechkraft der Mikrolinsen liegen, die durch eine starke Krümmung der Linsenoberflächen zu Abbildungsfehlern und damit vergrößerten, unscharfen reellen Zwischenbildern führt.

Figur 14 zeigt ein weiteres Beispiel. Im Unterschied zu Figur 13 liegen hier die Zwischenbilder 108a-b getrennt und nicht übereinander, aber vorzugsweise in sehr enger Nachbarschaft. Der Nachteil des vergrößerten Divergenzwinkels bleibt bestehen.

Der Ansatz mit Mikrolinsen funktioniert nur so lange einigermaßen gut, wie die Einzellichtquellen 102a-b vergleichsweise klein und weit voneinander getrennt sind. In vielen Fällen sind aber bei einem VCSEL die Lichtemissionsflächen im Vergleich zu ihrem gegenseitigen Abstand groß. Nun müssen die Mikrolinsen 106a-b sehr dicht an die jeweilige Lichtemissionsfläche herankommen, damit sie selektiv nur von deren Licht beleuchtet werden. Aus einer derart kleinen Distanz hat jedoch die Lichtemissionsfläche eine große räumliche Winkelausdehnung. Die Mikrolinse 106a-b muss daher jeweils ein großes Bildfeld abdecken. Dafür ist eine einzelne Linse nur begrenzt geeignet, die Abbilder werden deshalb deutlich unscharf, womit der erwünschte Effekt der Verkleinerung wieder verloren geht.

Die DE 101 56 282 A2 offenbart einen Laserscanner, der als Lichtquelle eine Lasermatrix verwendet. Deren Einzellaser senden aber jeweils einen eigenen Abtaststrahl aus, um ein Entfernungsbild mit so vielen einzelnen Entfernungspunkten zu erhalten, wie die Lasermatrix Einzellaser enthält.

Die DE 10 2011 052 802 A1 offenbart eine 3D-Kamera mit einer Beleuchtungseinheit, die eine Vielzahl von Einzelemittern mit jeweiligen Mikrooptiken in Form von Prismen und Linsen aufweist. Damit wird ein strukturiertes Beleuchtungsmuster erzeugt, wobei jeweils ein Einzelemitter einen Lichtpunkt beiträgt, der mittels der zugehörigen Mikrooptik an einen bestimmten Ort projiziert wird, um insgesamt ein pseudo-zufälliges Muster zu erhalten. Hier ist aber nicht das Ziel, mit einem kleinen Lichtfleck ein Objekt anzutasten, sondern im Gegenteil den gesamten Erfassungsbereich auszuleuchten.

Aus der WO 2014/102341 A1 ist ein weiteres optisches System bekannt, das ein strukturiertes Lichtmuster erzeugt, wobei erneut die Kombination von Mikroprismen und Mikrolinsen zum Einsatz kommen kann.

Die US 2013/0266326 A1 offenbart Mikrolinsen für ein mehrstrahliges VCSEL-Array. Die anhand der Figuren 13 und 14 diskutierte Problematik wird dabei aber nicht diskutiert oder gar gelöst.

Die US 2016/0182891 A1 offenbart ein integriertes Kamerasystem, in dem mehrere Arrays von Lichtquellen jeweils einen Teil des Sichtfeldes beleuchten. Dem jeweiligen Array ist ein optisches Element zugeordnet, das auf seiner den Lichtquellen zugewandten Unterseite ein Mikrolinsenfeld und auf seiner Oberseite eine Linsenstruktur aufweist.

In der EP 2 560 366 A2 wird eine 3D-Kamera mit einer Beleuchtung vorgestellt, die ein pseudozufälliges Punktmuster erzeugt. Dazu wird einem regelmäßigen Array von Einzelemittern ein Mikroprismenfeld vorgeordnet, das die Einzellichtstrahlen unterschiedlich ablenkt, und das so entstehende unregelmäßige Beleuchtungsmuster wird mittels einer Linse projiziert.

Daher ist Aufgabe der Erfindung, einen gattungsgemäßen tastenden Sensor mit einem Lichtsender aus mehreren Einzellichtquellen zu verbessern.

Diese Aufgabe wird durch einen optoelektronischen Sensor und ein Verfahren zum Erfassen von Objekten in einem Überwachungsbereich nach Anspruch 1 beziehungsweise 12 gelöst. Mit einem Lichtsender, der eine Vielzahl von Einzellichtquellen aufweist, wird ein Sendelichtbündel aus den jeweiligen Einzellichtbündeln ausgesandt. Das im Überwachungsbereich remittierte Licht wird wieder empfangen und daraus ein Empfangssignal erzeugt, das dann ausgewertet wird.

Die Erfindung geht von dem Grundgedanken aus, eine nicht-abbildende Mikrooptik zum effektiven Zusammenrücken oder Verdichten der Einzellichtquellen zu verwenden. Dazu ist ein optisches Umlenkelement mit den Einzellichtquellen zugeordneten, nichtabbildenden Mikrooptikbereichen vorgesehen. Sie lenken die Einzellichtbündel nach innen aufeinander zu. Da die Mikrooptikbereiche insbesondere nicht-abbildend sind, wird auf ein reelles Zwischenbild verzichtet, ein virtuelles Bild ist ausreichend, denn wie einleitend erläutert, würde weder eine zusätzliche Einzellinse noch Mikrolinsen das gewünschte Ergebnis erreichen können. Die Mikrooptikbereiche lenken das Einzellichtbündel um, ohne den Divergenzwinkel zwischen Mikrooptik und Sendelinse unvorteilhaft zu vergrößern. Die Einzellichtbündel scheinen nun virtuell aus einer kleineren Fläche zu stammen als ursprünglich physisch auf dem Lichtsender: Der Lichtsender verhält sich wie ein Lichtsender mit kompakterer Anordnung der Einzellichtquellen in der virtuellen Bildebene. Gemessen wird diese kleinere Fläche beispielsweise an einem Umkreis um die Einzellichtbündel beziehungsweise die Einzellichtquellen. Die Einzellichtbündel selbst werden nur umgelenkt und daher in ihrem Querschnitt nicht kleiner, wobei aber eine gewisse Formverzerrung einschließlich einer Verkleinerung nicht ausgeschlossen ist.

Die Erfindung hat den Vorteil, dass Querschnitt des ausgesandten Sendelichtbündels und damit Sendelichtfleck im Überwachungsbereich wie Empfangslichtfleck auf dem Lichtempfänger verkleinert werden. Damit wird die Auflösung verbessert, und es gibt weniger Lichtverluste auf dem Lichtempfänger über Temperatur, Toleranzen und dergleichen. Das Sendelichtbündel aus mehreren Einzellichtbündeln wird so transformiert, dass es virtuell aus einem kleineren Ortsbereich erzeugt ist, ohne dabei die Winkelverteilung unvorteilhaft zu vergrößern. Da auf eine Abbildung verzichtet wird, ist keine große Linsenkrümmung erforderlich, und die einleitend genannten Abbildungsfehler werden vermieden oder jedenfalls deutlich reduziert. Das optische Umlenkelement ist als Glaspressling, Kunststoffspritzgussteil oder mit anderen bekannten Herstellungsverfahren für Mikrooptiken preisgünstig herstellbar.

Der Lichtsender weist bevorzugt eine VCSEL mit mehreren Lichtemissionsflächen (Mesa) als Einzellichtquellen auf. Wie einleitend erläutert, bietet es herstellungstechnische Vorteile, eine VCSEL nicht mit einer, sondern mit mehreren Lichtemissionsflächen auszubilden. Es besteht daher ein besonderer Bedarf für das erfindungsgemäße optische Umlenkelement, um dennoch effektiv kleine Lichtflecken zu erhalten. So können preisgünstige VCSEL mit produktionssicheren kleinen Abstrahlwinkeln durch mehrere kleinere Lichtemissionsflächen auch in Sensoren, insbesondere Lichttastern und Laserscannern, mit einem feinen Abtaststrahl genutzt werden. Alternativ sind als Lichtsender andere Mehrfach-Laser oder Mehrfach-LED in gemeinsamer integrierter Matrixanordnung oder auch als separierte Einzellichtquellen möglich.

Zumindest ein Teil der Einzellichtquellen ist bevorzugt auf einem Kreis angeordnet. Das ist eine einfache und häufig genutzte Anordnung insbesondere für einige, also beispielsweise höchstens zehn Lichtemissionsflächen einer VCSEL. Das optische Umlenkelement sorgt hier dafür, dass sich der Kreis einschnürt, demnach in der virtuellen Bildebene einen kleineren Radius hat. Mehrere konzentrische Kreise sind ebenfalls denkbar, wobei das optische Umlenkelement dann etwas aufwändiger geformt sein muss.

Der Teil der Einzellichtquellen bildet vorzugsweise ein regelmäßiges n-Eck. Die Einzellichtquellen liegen dann nicht nur auf einem Kreis, sondern auch in gleichen Abständen zueinander. Solche regulären Anordnungen sind besonders vorteilhaft, da sie leichter zu handhaben sind und im Sendelichtbündel zu einer gleichmäßigeren Lichtverteilung führen.

Nicht auf dem Kreis angeordnete Einzellichtquellen sind vorzugsweise in der Mitte des Kreises angeordnet. Diese Mitte entspricht auch dem Schwerpunkt des regelmäßigen n-Ecks, sofern ein Teil der Einzellichtquellen derart angeordnet ist. Das führt zu einer die Fläche ausnutzenden, regelmäßigen Anordnung von Einzellichtquellen. Vorzugsweise gibt es über die auf dem Kreis und in der Mitte angeordneten Einzellichtquellen hinaus keine weiteren.

Die Mikrooptikbereiche weisen bevorzugt Lichtwellenleiter auf. Das erfordert eine etwas komplexere Herstellung des optischen Umlenkelements. Mit Lichtleitern lässt sich der Austrittsort und -winkel des Einzellichtbündels praktisch beliebig individuell wählen und so insgesamt eine geeignete Anordnung von virtuellen Einzellichtquellen finden.

Die Mikrooptikbereiche weisen bevorzugt gegenüber der optischen Achse der zugeordneten Einzellichtquelle verkippte Planflächen auf. Damit wirken die Mikrooptikbereiche als Prismen, die das Licht der zugeordneten Einzellichtquelle in der gewünschten Weise nach Innen hin versetzen.

Die Planflächen bilden bevorzugt die Seitenflächen einer Pyramide oder eines Pyramidenstumpfes. Die Grundfläche der Pyramide entspricht der Anordnung der Einzellichtquellen, also insbesondere einem regelmäßigen n-Eck. Dabei sitzen die Einzellichtquellen aber vorzugsweise nicht in den Ecken der Grundfläche. Betrachtet man eine Projektion der Seitenflächen auf die Grundfläche, so liegen die Einzellichtquellen diesbezüglich zumindest einigermaßen zentral, damit das ganze Einzellichtbündel die Seitenfläche und keine Kanten trifft. Das n-Eck der Einzellichtquellen ist also gegenüber der Grundfläche verdreht, insbesondere um 360°/2n, und außerdem verkleinert. Die Mitte der Pyramide ist optisch nur relevant, wenn es zusätzlich zu dem n-Eck mindestens eine weitere mittige Einzellichtquelle gibt. Deren Einzellichtbündel muss nicht abgelenkt werden, da es bereits zentral im Sendelichtbündel liegt. Deshalb kann die Pyramide einfach plan abgeschnitten werden, so dass sich ein Pyramidenstumpf ergibt. Gibt es keine mittigen Einzellichtquellen, so kann die Spitze der Pyramide allein nach herstellungstechnischen Gesichtspunkten gestaltet sein, also ebenfalls abgeschnitten, aber auch gerundet oder dergleichen.

Das Umlenkelement weist bevorzugt einen Hohlkegel oder Hohlkegelstumpf auf, dessen Mantelfläche Mikrooptikbereiche bildet. Das ist gleichsam die kontinuierliche Version einer Pyramide, die insgesamt und nicht nur für einige feste Winkel rotationssymmetrisch ist. Optisch könnte es als konvex-konkaves Axikon betrachtet werden. Ein Hohlkegel ist je nach Material und Herstellungsverfahren preisgünstiger und muss in Umfangsrichtung nicht justiert werden. In einem Hohlkegel ist die jeweilige Einzellichtquelle faktisch eine Seitenfläche ähnlich wie in einer Pyramide zugeordnet. Die Krümmung dieser Seitenfläche in Umfangsrichtung ist nicht besonders groß, da der Querschnitt des Einzellichtbündels nur einem kleinen Winkelbereich des Hohlkegels entspricht. Der dadurch erzeugte Astigmatismus ist in vielen Fällen hinnehmbar. Die Ausführungen zur Spitze der Pyramide gelten sinngemäß auch für einen Hohlkegel, der also insbesondere als Hohlkegelstumpf oder mit gerundeter Spitze ausgebildet ist.

Die Auswertungseinheit ist bevorzugt dafür ausgebildet, aus einer Lichtlaufzeit des ausgesandten und wieder empfangenen Sendelichtbündels oder mittels Triangulation einen Abstand des remittierenden oder angetasteten Objekts zu bestimmen. So entsteht ein entfernungsmessender Sensor beziehungsweise Taster. Das Lichtlaufzeitverfahren ist an sich bekannt, und es kann beispielsweise ein Puls-, Phasen- oder Pulsmittelungsverfahren eingesetzt werden. Triangulation ist ebenfalls an sich bekannt. Einen Spezialfall bilden sogenannte hintergrundausblendende Taster, deren Erfassungssignal nur binär die Anwesenheit eines Objekts feststellt, jedoch mittels Triangulationsauswertung nur innerhalb eines bestimmten Abstandsbereichs.

Vorzugsweise ist der Sensor als Laserscanner ausgebildet und weist dazu eine bewegliche Ablenkeinheit auf, um das Sendelichtbündel periodisch in dem Überwachungsbereich abzulenken. Gegenüber einem einstrahligen Sensor oder Taster wird dadurch der Überwachungsbereich auf eine Ebene oder, wenn die Ablenkeinheit in zwei Achsen beweglich ist, sogar einen dreidimensionalen Raumbereich erweitert. Die Ablenkeinheit kann ein Schwenk- oder Drehspiegel, ebenso aber ein rotierender oder schwingender Abstastkopf sein, in dem auch mehrere Messmodule in gleichen und/oder versetzten Winkeln angeordnet sein können, um gleichzeitig mehr Messwerte aus einem größeren Überwachungsbereich zu erfassen.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Schnittdarstellung eines optoelektronischen Sensors;
- Fig. 2: eine Schnittdarstellung einer Ausführungsform eines Lichtsenders mit optischem Umlenkelement und nachgeordneter Sendeoptik;
- Fig. 3: eine vergrößerte Darstellung des Umlenkelements gemäß Figur 2 und des Strahlengangs;
- Fig. 4: eine Draufsicht auf ein optisches Umlenkelement, das zwei Einzellichtquellen virtuell zusammenrückt oder verdichtet;
- Fig. 5: eine schematische Darstellung des virtuellen Zusammenrückens oder Verdichtens von drei Einzellichtquellen durch ein weiteres optisches Umlenkelement;
- Fig. 6: eine Draufsicht auf ein optisches Umlenkelement für drei Einzellichtquellen;
- Fig. 7: eine dreidimensionale Darstellung einer Ausführungsform eines optischen Umlenkelements für drei Einzellichtquellen;
- Fig. 8: eine Draufsicht auf ein optisches Umlenkelement für vier Einzellichtquellen;
- Fig. 9: eine Draufsicht auf ein optisches Umlenkelement für sieben Einzellichtquellen;
- Fig. 10: eine dreidimensionale Ansicht eines weiteren optischen Umlenkelements mit Lichtleitern;
- Fig. 11: eine Schnittdarstellung eines optischen Umlenkelements mit Lichtleiter beziehungsweise Totalreflexion;
- Fig. 12: eine Schnittdarstellung zur Erläuterung, warum eine einzelne Zusatzlinse nicht geeignet ist;
- Fig. 13: eine Schnittdarstellung eines Lichtsenders mit Mikrolinsen, die Einzellichtquellen auf ein gemeinsames reelles Zwischenbild abbilden; und
- Fig. 14: eine Schnittdarstellung wie Figur 13, jedoch mit separaten reellen Zwischenbildern.

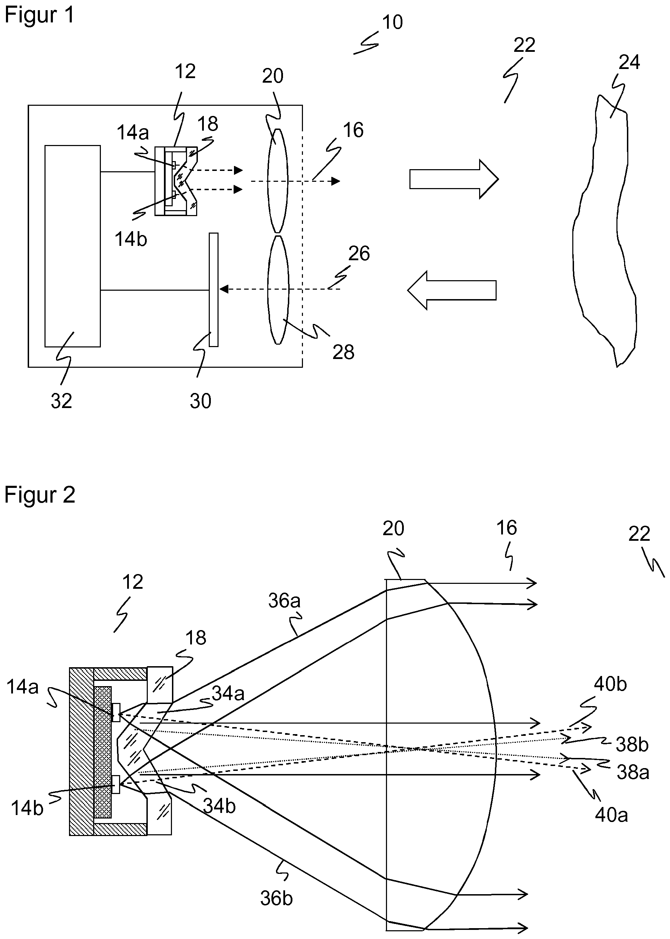

Figur 1 zeigt eine schematische Schnittdarstellung eines optoelektronischen Sensors 10. Ein Lichtsender 12 weist mehrere Einzellichtquellen 14a-b auf, im dargestellten Beispiel zwei Einzellichtquellen 14a-b. Deren Einzellichtbündel bilden gemeinsam ein Sendelichtbündel 16, dessen Querschnitt zunächst mit Hilfe eines optischen Umlenkelements 18 verringert wird und das dann über eine gemeinsame Sendeoptik 20, vorzugsweise eine Einzellinse, in einen Überwachungsbereich 22 ausgesandt wird.

Der Lichtsender 12 ist vorzugsweise eine VCSEL, und dann sind die Einzellichtquellen 14a-b durch die Lichtemissionsflächen (Mesa) gebildet. Alternativ sind andere Laserlichtquellen oder LEDs denkbar. Die Zusammenfassung von Lichtsender 12 und optischem Umlenkelement 18 als gemeinsames Bauteil in Figur 1 ist vorteilhaft, aber die Erfindung darauf nicht beschränkt. Der optische Effekt und mögliche Ausführungsformen des optischen Umlenkelements 18 werden später unter Bezugnahme auf die Figuren 2 bis 11 näher erläutert.

Trifft das Sendelichtbündel 16 im Überwachungsbereich 22 auf ein Objekt 24, so kehrt ein Teil des Lichts als remittiertes Sendelichtbündel 26 zu dem Sensor 10 zurück und wird dort von einer Empfangsoptik 28 auf einen Lichtempfänger 30 gebündelt, der beispielsweise als Photodiode, APD (Avalanche Photodiode), SPAD (Single-Photon Avalanche Photodiode) oder eine Mehrfachanordnung solcher Empfangselemente ausgebildet ist.

Eine Auswertungseinheit 32 steuert den Lichtsender 12 und wertet das Empfangssignal des Lichtempfängers 30 aus, um festzustellen, ob das Sendelichtbündel 16 ein Objekt 24 erfasst hat. In einer bevorzugten Ausführungsform wird auch der Abstand zu dem Objekt 24 bestimmt. Das dabei eingesetzte Lichtlaufzeitverfahren kann ein Einzelpuls- oder Mehrpulsverfahren, aber auch ein Phasenverfahren sein und ist an sich bekannt. Auch ein Triangulationsverfahren ist denkbar.

Figur 1 zeigt eine beispielhafte biaxiale Bauform des Sensors 10. Die Erfindung ist darauf nicht beschränkt, sondern umfasst jegliche tastenden optoelektronischen Sensoren. So ist insbesondere eine koaxiale Anordnung von Lichtsender 12 und Lichtempfänger 30 durch einen vor dem Lichtempfänger angeordneten Lichtsender 12 oder mittels Strahlteiler denkbar. Außerdem kann der Sensor 10 statt eines einstrahligen Tasters ein Laserscanner sein, indem das Sendelichtbündel periodisch durch einen beweglichen Spiegel abgelenkt wird oder ein beweglicher Optikkopf vorgesehen ist, in dem Lichtsender 12 und/oder Lichtempfänger 30 mitbewegt werden.

Wie einleitend erläutert, würde allein nach Abbildung der Sendeoptik 20 der Querschnitt des Sendelichtbündels 16, damit die Größe des Lichtflecks auf dem Objekt 24 und des Empfangslichtflecks auf dem Lichtempfänger 30, durch die mehreren Einzellichtquellen 14a-b im Vergleich zu einer einzigen Lichtquelle deutlich vergrößert. Das optische Umlenkelement 18 dient dazu, auch für einen Lichtsender 12 mit mehreren Einzellichtquellen 14a-b ein feines Sendelichtbündel 16 mit geringem Querschnitt und damit kleine Lichtflecken zu erreichen. Dieser Effekt des optischen Umlenkelements 18 wird nun anhand einer Reihe von Ausführungsbeispielen näher betrachtet.

Figur 2 zeigt den Lichtsender 12 samt des optischen Umlenkelements 18 gemäß Figur 1 in einer vergrößerten Darstellung. Das optische Umlenkelement 18 ist insgesamt grob eine Planplatte, die jedoch eine beidseitig eingeprägte Mikrooptik 34a-b hier in Form von zwei zueinander parallelen, gegenüber der optischen Achse des Lichtsenders 12 gekippten Planflächen für jede Einzellichtquelle 14a-b aufweist. Die Mikrooptik 34a-b wirkt auf die Einzellichtbündel 36a-b der Einzellichtquellen 14a-b wie ein Doppelprisma. Durch dessen Umlenkung scheinen die Einzellichtbündel 36a-b aus näher zusammengerückten Einzellichtquellen 14a-b und damit insgesamt einer kleineren Fläche des Lichtsenders 12 zu stammen. Zur Veranschaulichung sind die Hauptstrahlen 38a-b der Einzellichtbündel 36a-b eingezeichnet, die wegen des optischen Umlenkelements 18 einen kleineren Winkel einschließen als zum Vergleich dargestellte Hauptstrahlen 40a-b für den Fall ohne optisches Umlenkelement 18.

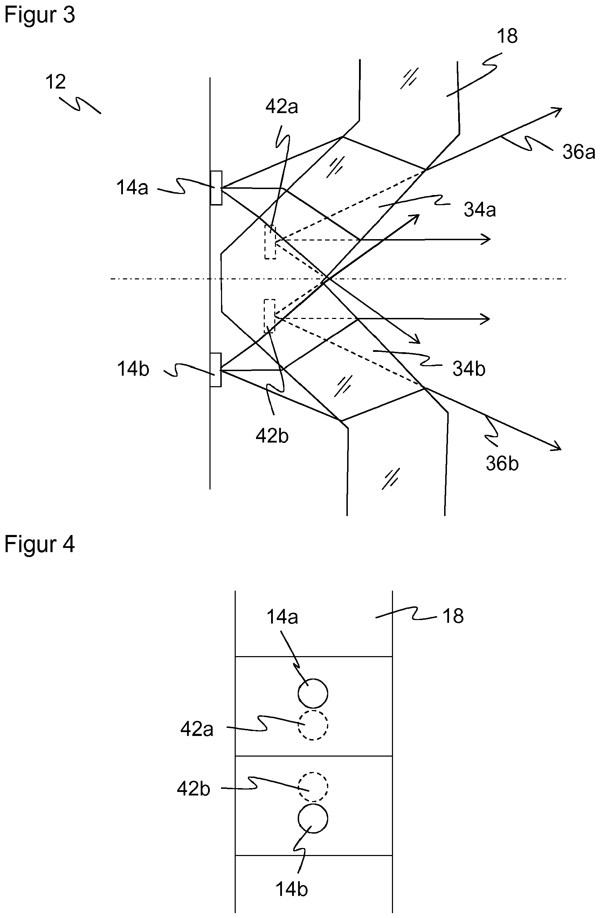

Figur 3 zeigt eine nochmals vergrößerte Ansicht des Strahlengangs an dem optischen Umlenkelement 18. Die Einzellichtbündel 36a-b werden durch die Mikrooptiken 34a-b nach innen hin umgelenkt. Dadurch gibt es zwei zusammengerückte virtuelle Bilder 42a-b der Einzellichtquellen 14a-b, die zueinander einen kleineren Abstand haben und damit eine kleinere Fläche einnehmen als die Einzellichtquellen 14a-b selbst. Dabei ist der Radius der Einzellichtquellen 14a-b und der virtuellen Bilder 42a-b für sich ungefähr gleich, da die Mikrooptiken 34a-b nur umlenken und nicht abbilden. Der Radius eines Umkreises um die Einzellichtquellen 14a-b dagegen ist erheblich größer als derjenige eines Umkreises um die virtuellen Bilder 42a-b.

Figur 4 illustriert die zusammengerückten virtuellen Bilder 42a-b ein weiteres Mal in einer Draufsicht auf das optische Umlenkelement 18. Wie schon erläutert, ist die Größe der Einzellichtquellen 14a-b und ihrer jeweiligen virtuellen Bilder 42a-b in etwa gleich, wobei gewisse Form- und Größenverzerrungen denkbar sind. Die virtuellen Bilder 42a-b liegen aber deutlich näher beieinander, so dass sie insgesamt eine kleinere Fläche einnehmen beziehungsweise von einem kleineren Umkreis eingeschlossen werden.

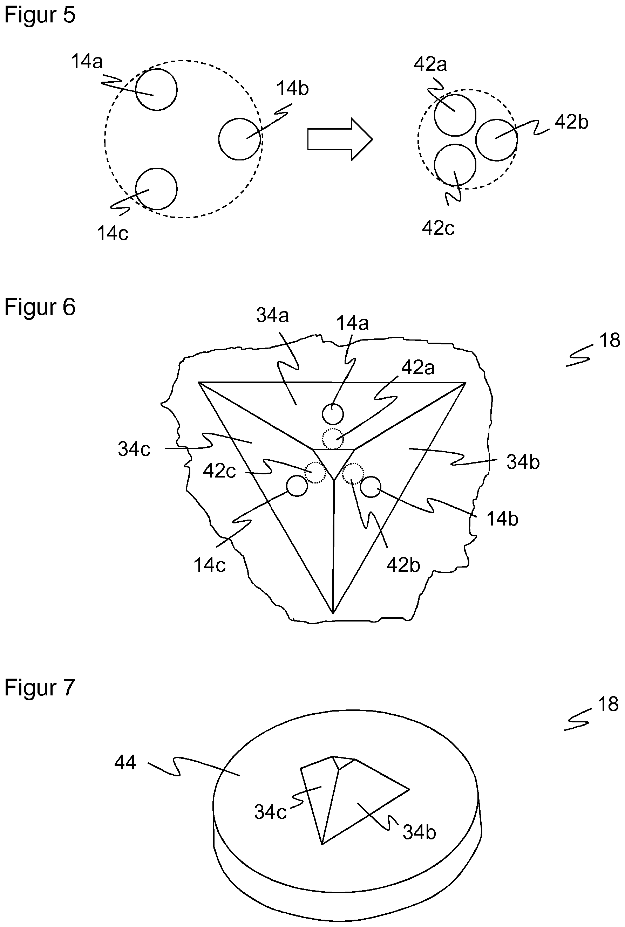

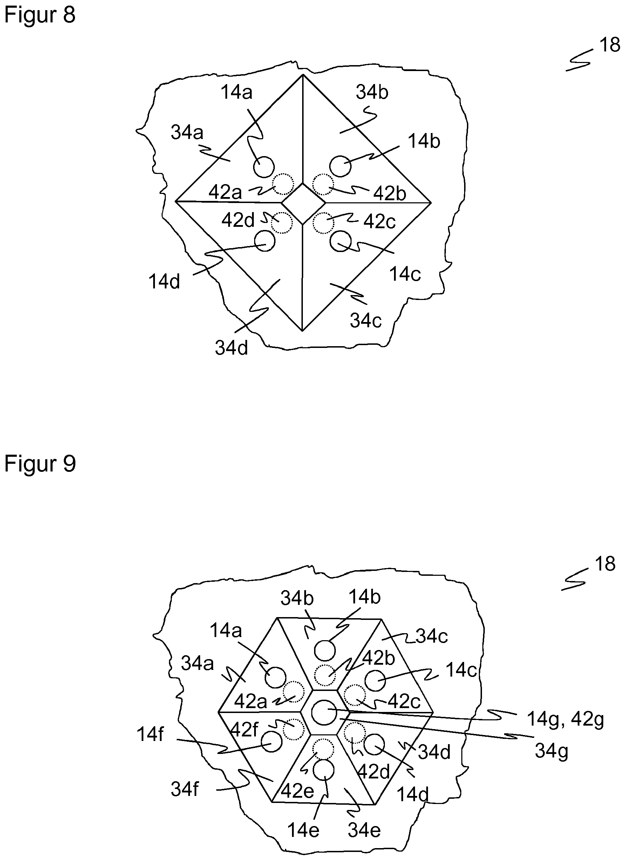

Der Lichtsender 12 weist in den bisherigen Beispielen nur zwei Einzellichtquellen 14a-b auf. Die Erfindung ist nicht auf nur zwei Einzellichtquellen 14a-b beschränkt. Zunächst lassen sich die Darstellungen alternativ als Schnittdarstellungen durch mehr als zwei ringförmig angeordnete Einzellichtquellen 14a-b auffassen. Weiterhin zeigen die Figuren 5 bis 7 ein Ausführungsbeispiel für drei Einzellichtquellen 14a-c, die Figur 8 ein Ausführungsbeispiel für vier Einzellichtquellen 14a-d und die Figur 9 ein Ausführungsbeispiel für sieben Einzellichtquellen 14a-g. Entsprechend können optische Umlenkelemente 18 für Lichtsender 12 mit einer anderen Anzahl von Einzellichtquellen gestaltet werden.

Figur 5 illustriert das Zusammenrücken von drei Einzellichtquellen 14a-c auf drei virtuelle Bilder 42a-c. Wie schon zu Figur 4 diskutiert, sind die virtuellen Bilder 42a-c selbst praktisch genauso groß wie die Einzellichtquellen 14a-c selbst, jedoch auf deutlich kleinerer Fläche innerhalb eines kleineren Umkreises.

Figur 6 zeigt eine dafür mögliche Gestaltung des optischen Umlenkelements 18 in der Draufsicht. Die Mikrooptikbereiche 34a-c bilden die Seitenflächen einer Dreieckspyramide. Diese Pyramide ist hohl, denn die Mikrooptikbereiche 34a-c sind Planflächen analog zu den Figuren 2 bis 4. Die Spitze der Pyramide ist optisch nicht relevant und hier aus herstellungstechnischen Gründen abgeschnitten.

Figur 7 zeigt ein entsprechendes optisches Umlenkelement 18 in dreidimensionaler Ansicht. Die Pyramide beziehungsweise der Pyramidenstumpf mit den Mikrooptikbereichen ist zur besseren Handhabung beidseitig in eine Planfläche 44 eingeprägt. Die Ansicht lässt sich gleichermaßen als Ansicht von oben auf die Spitze der Pyramide wie von unten in den inneren Hohlraum der Pyramide auffassen.

Mit einem derart aufgebauten optischen Umlenkelement 18 wird eine erhebliche Verkleinerung des Umkreises auf beispielsweise 60% erreicht. Die Lichtverluste sind mit 10-15% gering, außerdem handelt es sich hauptsächlich um Fresnel-Reflexe, die durch eine Antireflex-Beschichtung weiter verringert werden könnten.

Figur 8 ist eine der Figur 6 entsprechende Ansicht, jedoch für vier Einzellichtquellen 14a-d. Figur 9 zeigt ein weiteres Beispiel für sieben Einzellichtquellen 14a-g. Dabei ist eine der Einzellichtquellen 14g zentral angeordnet, und der zugehörige Mittenbereich des optischen Umlenkelements 18 ist hier offen oder eine senkrechte Planplatte, da vorzugsweise das zentral ausgesandte Licht nicht umgelenkt wird. Es ist vorteilhaft, wenn die Grundfläche der Pyramide ein regelmäßiges n-Eck ist, um eine gleichmäßige Lichtverteilung und Umlenkung zu erzielen. Die Verallgemeinerung auf ein anderes n ist aus den Beispielen ersichtlich. Dabei können auch mehrere konzentrische Ringe von Einzellichtquellen gebildet werden, vorzugsweise wäre dann das optische Umlenkelement 18 aus mehreren gestapelten Pyramiden mit unterschiedlich steilen Seitenwänden ausgebildet. Andere Anordnungen der Einzellichtquellen sind auch möglich, denen dann vorzugsweise entsprechende gekippte Planflächen zugeordnet sind, wobei dann andere geometrische Körper entstehen.

Es ist auch vorstellbar, statt gekippter Planflächen Krümmungen zuzulassen, auch wenn dies gewisse optischen Verzerrungen nach sich zieht. Ein Beispiel hierfür ist die Gestaltung des optischen Umlenkelements 18 mit einem Hohlkegel anstelle einer Pyramide. Das Schnittbild beziehungsweise die Ausschnittansicht wäre identisch zu den Figuren 1 bis 4. Allerdings ist das optische Umlenkelement 18 dann rotationssymmetrisch. Die Krümmung in Umfangsrichtung führt einen leichten Astigmatismus ein, der aber vernachlässigt oder zumindest hingenommen werden kann. Das entsprechend geformte optische Umlenkelement 18 kann als konvex-konkaves Axikon bezeichnet werden. Es bietet den Vorteil, dass es je nach Herstellungsverfahren mit seiner inneren und äußeren Kegelmantelfläche einfacher, präziser und kostengünstiger zu fertigen ist. Außerdem ist es nicht auf eine bestimmte Anzahl von Einzellichtquellen beschränkt, sondern kann mit einer beliebigen Anzahl in einem Ring angeordneter Einzellichtquellen umgehen. Mindestens eine weitere zentral angeordnete Einzellichtquelle kann durch einen Kegelstumpf berücksichtigt werden. Mehrere konzentrische Ringe sind ebenfalls durch den Kegel, noch besser gestapelte Kegelstümpfe unterschiedlicher Steigung umlenkbar.

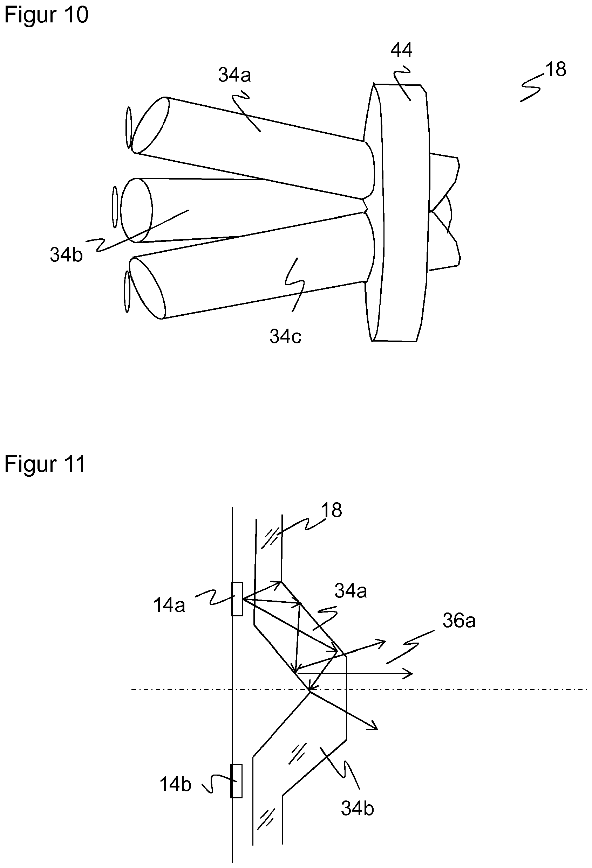

Figur 10 zeigt ein weiteres Ausführungsbeispiel des optischen Umlenkelements 18. Hier sind die Mikrooptikbereiche 34a-c als Lichtleiter mit passend verkippten Ein- und Austrittsflächen ausgebildet. Die Anzahl von drei Lichtleitern für drei Einzellichtquellen ist rein beispielhaft. Allgemein können ein oder zwei der Brechungen an den beiden Prismenflächen der Ausführungsbeispiele gemäß Figur 1 bis 9 durch Reflexionen an verspiegelten Flächen oder eine Totalreflexion ersetzt werden. Die Lichtleiter können demnach nicht nur Vollkörper aus transparentem Material, sondern auch hohle, innen verspiegelte Lichtleiter sein.

Figur 11 illustriert den Gedanken der Faltung des Strahlengangs mittels Totalreflexion an einer Schnittdarstellung eines weiteren Ausführungsbeispiels des optischen Umlenkelements 18. Das wird hier auch als Lichtleiter bezeichnet, weil es das gleiche optische Wirkprinzip ist.

Die erläuterten Ausführungsbeispiele beziehen sich auf den Lichtsender 12, dessen von mehreren Einzellichtquellen erzeugter Lichtfleck durch das optische Umlenkelement 18 verkleinert wird. Das optische Umlenkelement könnte aber auch empfangsseitig eingesetzt werden, etwa bei einem ortsauflösenden Lichtempfänger 30 insbesondere mit mehreren Lichtempfangselementen, wie ein Photodioden-Array, ein APD-Array oder ein SPAD-Array.

## Patentansprüche

1. Optoelektronischer Sensor (10) zum Erfassen von Objekten (24) in einem Überwachungsbereich (22), der als einstrahliger Taster oder Laserscanner ausgebildet ist und der einen Lichtsender (12) mit einer Vielzahl von Einzellichtquellen (14) und einer vorgeordneten Sendeoptik (20) zum Aussenden eines Sendelichtbündels (16), das sich aus Einzellichtbündeln (36) der Einzellichtquellen (14) zusammensetzt und in dem Überwachungsbereich (22) einen Sendelichtfleck erzeugt, einen Lichtempfänger (30) zum Erzeugen eines Empfangssignals aus dem in dem Überwachungsbereich (22) remittierten und auf den Lichtempfänger (30) fallenden Sendelichtbündel (26), das einen Empfangslichtfleck auf dem Lichtempfänger (30) erzeugt sowie eine Auswertungseinheit (32) zum Erfassen der Objekte (24) aus dem Empfangssignal aufweist,
**dadurch gekennzeichnet,**
**dass** zwischen Lichtsender (12) und Sendeoptik (20) ein optisches Umlenkelement (18) angeordnet ist, das Sendelichtfleck wie Empfangslichtfleck verkleinert, wobei das optische Umlenkelement (18) den Einzellichtquellen (14) zugeordnete, nicht-abbildende Mikrooptikbereiche (34) aufweist, welche die Einzellichtbündel (36) derart aufeinander zu umlenken, dass die Querschnitte der Einzellichtbündel (36) in einer virtuellen Bildebene (42) vor der Sendeoptik (20) gemeinsam eine kleinere Fläche einnehmen als die Einzellichtquellen (14) selbst, so dass der Lichtsender (12) sich wie ein Lichtsender mit kompakterer Anordnung von Einzellichtquellen in der virtuellen Bildebene (42) verhält, bei dem die Einzellichtbündel (36) aus einer kleineren Fläche zu stammen scheinen als ursprünglich physisch auf dem Lichtsender (12).

2. Sensor (10) nach Anspruch 1,
wobei der Lichtsender (12) eine VCSEL mit mehreren Lichtemissionsflächen als Einzellichtquellen (14) aufweist.

3. Sensor (10) nach Anspruch 1 oder 2,
wobei zumindest ein Teil der Einzellichtquellen (14) auf einem Kreis angeordnet ist.

4. Sensor (10) nach Anspruch 3,
wobei der Teil der Einzellichtquellen (14) ein regelmäßiges n-Eck bildet.

5. Sensor (10) nach Anspruch 3 oder 4,
wobei nicht auf dem Kreis angeordnete Einzellichtquellen (14g) in der Mitte des Kreises angeordnet sind.

6. Sensor (10) nach einem der vorhergehenden Ansprüche,
wobei die Mikrooptikbereiche (34) Lichtwellenleiter aufweisen.

7. Sensor (10) nach einem der vorhergehenden Ansprüche,
wobei die Mikrooptikbereiche (34) gegenüber der optischen Achse der zugeordneten Einzellichtquelle (14) verkippte Planflächen aufweisen.

8. Sensor (10) nach Anspruch 7,
wobei die Planflächen die Seitenflächen einer Pyramide oder eines Pyramidenstumpfes bilden.

9. Sensor (10) nach einem der Ansprüche 1 bis 7,
wobei das Umlenkelement (18) einen Hohlkegel oder Hohlkegelstumpf aufweist, dessen Mantelfläche Mikrooptikbereiche (34) bildet.

10. Sensor (10) nach einem der vorhergehenden Ansprüche,
wobei die Auswertungseinheit (32) dafür ausgebildet ist, aus einer Lichtlaufzeit des ausgesandten und wieder empfangenen Sendelichtbündels (16, 26) oder mittels Triangulation einen Abstand des remittierenden Objekts (24) zu bestimmen.

11. Sensor (10) nach einem der vorhergehenden Ansprüche,
der als Laserscanner ausgebildet ist und dazu eine bewegliche Ablenkeinheit aufweist, um das Sendelichtbündel (16) periodisch in dem Überwachungsbereich (22) abzulenken.

12. Verfahren zum Erfassen von Objekten (24) in einem Überwachungsbereich (22) mittels eines als einstrahliger Taster oder Laserscanner ausgebildetem optoelektronischen Sensor, wobei ein Sendelichtbündel (16), das sich aus einer Vielzahl von Einzellichtbündeln (36) von Einzellichtsendern (14) eines Lichtsenders (12) zusammensetzt, durch eine Sendeoptik (20) ausgesandt wird und in dem Überwachungsbereich (22) einen Sendelichtfleck erzeugt, aus dem in dem Überwachungsbereich (22) remittierten Sendelichtbündel (26) ein Empfangslichtfleck und daraus ein Empfangssignal erzeugt und das Empfangssignal ausgewertet wird, um die Objekte (24) zu erfassen,
**dadurch gekennzeichnet,**
**dass** mit einem optischen Umlenkelement (18) Sendelichtfleck wie Empfangslichtfleck verkleinert werden, wobei von dem optischen Umlenkelement (18) die Einzellichtbündel (36) vor Eintritt in die Sendeoptik (20) mit Hilfe von nicht-abbildenden Mikrooptikbereichen (34) aufeinander zu umgelenkt werden, so dass die Querschnitte der Einzellichtbündel (36) in einer virtuellen Bildebene (42) vor der Sendeoptik (20) gemeinsam eine kleinere Fläche einnehmen als während ihrer Erzeugung , so dass der Lichtsender (12) sich wie ein Lichtsender mit kompakterer Anordnung von Einzellichtquellen in der virtuellen Bildebene (42) verhält, bei dem die Einzellichtbündel (36) aus einer kleineren Fläche zu stammen scheinen als ursprünglich physisch auf dem Lichtsender (12).

## Claims

1. An optoelectronic sensor (10) for detecting objects (24) in a monitoring area (22), configured as a single-beam system or as a laser scanner and comprising a light transmitter (12) having a plurality of individual light sources (14) with transmitting optics (20) for transmitting a transmitted light beam (16) that is composed of individual light beams (36) from the individual light sources (14) and generates a transmitted light spot in the monitoring area (22), a light receiver (30) for generating a received signal from the transmitted light beam (26) that has been remitted in the monitoring region (22) and impinges on the light receiver (30) to generate a received light spot on the light receiver (30), and an evaluation unit (32) for detecting the objects (24) from the received signal,
**characterized in that** an optical deflecting element (18) is arranged between the light transmitter (12) and the transmitting optics (20), reducing the transmitted light spot and the received light spot in size, the optical deflecting element (18) comprising non-imaging micro-optical regions (34) that are assigned to the individual light sources (14) and that deflect the individual light beams (36) towards one another in such a manner that the cross-sections of the individual light beams (36) in a virtual image plane (42) in front of the transmitting optics (20) together occupy a smaller area than the individual light sources (14) themselves, so that the light transmitter (12) behaves like a light transmitter having a more compact arrangement of individual light sources in the virtual image plane (42), with the individual light beams (36) appearing to originate from a smaller area than originally physically on the light transmitter (12).

2. The sensor (10) according to claim 1,
wherein the light transmitter (12) comprises a VCSEL having a plurality of light transmitting surfaces as individual light sources (14).

3. The sensor (10) according to claim 1 or 2,
wherein at least a part of the individual light sources (14) is arranged on a circle.

4. The sensor (10) according to claim 3,
wherein the part of the individual light sources (14) forms a regular n-corner.

5. The sensor (10) according to claim 3 or 4,
wherein individual light sources (14g) not arranged on the circle are arranged in the centre of the circle.

6. The sensor (10) according to any of the preceding claims,
wherein the micro-optical regions (34) comprise optical waveguides.

7. The sensor (10) according to any of the preceding claims,
wherein the micro-optical regions (34) have planar surfaces tilted with respect to the optical axis of the associated single light source (14).

8. The sensor (10) according to claim 7,
wherein the planar surfaces form the side surfaces of a pyramid or a truncated pyramid.

9. The sensor (10) according to any of claims 1 to 7,
wherein the deflecting element (18) comprises a hollow cone or hollow truncated cone, the circumferential surface of which forms micro-optical regions (34).

10. The sensor (10) according to any of the preceding claims,
wherein the evaluation unit (32) is configured to determine a distance of the remitting object (24) from a light time of flight of the light beam (16, 26) transmitted and received again, or by means of triangulation.

11. The sensor (10) according to any of the preceding claims,
which is configured as a laser scanner and comprises a movable deflection unit in order to periodically deflect the transmitted light beam (16) in the monitoring area (22).

12. A method for detecting objects (24) in a monitoring area (22) using an optoelectronic sensor configured as a single-beam system or as a laser scanner, wherein a transmitted light beam (16), that is composed of a plurality of individual light beams (36) from individual light transmitters (14) of a light transmitter (12), is transmitted via transmitting optics (20) and generates a transmitted light spot in the monitoring region (22), a received light spot is generated from the transmitted light beam (26) remitted in the monitoring region (22), and a received signal is generated therefrom, and the received signal is evaluated in order to detect the objects (24),
**characterized in that** the transmitted light spot and the received light spot are reduced in size by means of an optical deflection element (18), the individual light beams (36) being deflected towards one another by the optical deflection element (18) with the aid of non-imaging micro-optical regions (34) before they enter the transmitting optics (20), so that the cross-sections of the individual light beams (36) in a virtual image plane (42) in front of the transmitting optics (20) together occupy a smaller area than during their generation, so that the light transmitter (12) behaves like a light transmitter with a more compact arrangement of individual light sources in the virtual image plane (42), with the individual light beams (36) appearing to originate from a smaller area than originally physically on the light transmitter (12).

## Revendications

1. Capteur optoélectronique (10) pour la détection d'objets (24) dans une zone à surveiller (22), qui est réalisé sous forme de palpeur ou scanner laser à faisceau unique et qui comprend un émetteur de lumière (12) ayant une pluralité de sources de lumière individuelles (14) et une optique d'émission (20) placée en amont pour émettre un faisceau lumineux d'émission (16) qui se compose de faisceaux lumineux individuels (36) provenant des sources de lumière individuelles (14) et qui génère une tache lumineuse d'émission dans la zone à surveiller (22), un récepteur de lumière (30) pour générer un signal de réception à partir du faisceau lumineux d'émission (26) renvoyé dans la zone à surveiller (22), incident sur le récepteur de lumière (30) et générant une tache lumineuse de réception sur le récepteur de lumière (30), ainsi qu'une unité d'évaluation (32) pour détecter les objets (24) à partir du signal de réception,
**caractérisé en ce que**
un élément de déflexion optique (18) est disposé entre l'émetteur de lumière (12) et l'optique d'émission (20) et réduit aussi bien la tache lumineuse d'émission que la tache lumineuse de réception, l'élément de déflexion optique (18) présentant des zones micro-optiques (34) non-imageurs associées aux différentes sources de lumière individuelles (14), qui défléchissent les faisceaux lumineux individuels (36) les uns vers les autres de telle manière que les sections transversales des faisceaux lumineux individuels (36) dans un plan d'image virtuel (42) devant l'optique d'émission (20) occupent conjointement une surface plus petite que celle des sources de lumière individuelles (14) elles-mêmes, de sorte que l'émetteur de lumière (12) se comporte comme un émetteur de lumière avec une disposition plus compacte de sources de lumière individuelles dans le plan d'image virtuel (42), dans lequel les faisceaux lumineux individuels (36) semblent provenir d'une surface plus petite que celle physiquement présente à l'origine sur l'émetteur de lumière (12).

2. Capteur (10) selon la revendication 1,
dans lequel l'émetteur de lumière (12) comprend un VCSEL ayant plusieurs surfaces d'émission de lumière à titre de sources de lumière individuelles (14).

3. Capteur (10) selon la revendication 1 ou 2,
dans lequel une partie au moins des sources de lumière individuelles (14) sont disposées sur un cercle.

4. Capteur (10) selon la revendication 3,
dans lequel la partie des sources de lumière individuelles (14) forment un polygone régulier à n coins.

5. Capteur (10) selon la revendication 3 ou 4,
dans lequel des sources de lumière individuelles (14g) non disposées sur le cercle sont disposées au centre du cercle.

6. Capteur (10) selon l'une des revendications précédentes,
dans lequel les zones micro-optiques (34) comprennent des fibres optiques.

7. Capteur (10) selon l'une des revendications précédentes,
dans lequel les zones micro-optiques (34) comprennent des surfaces planes inclinées par rapport à l'axe optique de la source de lumière individuelle (14) associée.

8. Capteur (10) selon la revendication 7,
dans lequel les surfaces planes forment les surfaces latérales d'une pyramide ou d'un tronc de pyramide.

9. Capteur (10) selon l'une des revendications 1 à 7,
dans lequel l'élément de déflexion (18) comprend un cône creux ou un tronc de cône creux, dont la surface enveloppe forme des zones micro-optiques (34).

10. Capteur (10) selon l'une des revendications précédentes,
dans lequel l'unité d'évaluation (32) est réalisée pour déterminer une distance de l'objet renvoyant (24) à partir d'un temps de parcours de lumière du faisceau lumineux d'émission (16, 26) émis et reçu, ou par voie de triangulation.

11. Capteur (10) selon l'une des revendications précédentes,
qui est réalisé sous forme de scanner laser et comprend à cet effet une unité de déviation mobile afin de dévier périodiquement le faisceau lumineux d'émission (16) dans la zone à surveiller (22).

12. Procédé de détection d'objets (24) dans une zone à surveiller (22) au moyen d'un capteur optoélectronique réalisé sous forme de palpeur ou scanner laser à faisceau unique,
dans lequel
un faisceau lumineux d'émission (16) qui se compose d'une pluralité de faisceaux lumineux individuels (36) provenant d'émetteurs de lumière individuels (14) d'un émetteur de lumière (12) est émis par une optique d'émission (20) et génère une tache lumineuse d'émission dans la zone à surveiller (22),
une tache lumineuse de réception est générée à partir du faisceau lumineux d'émission (26) renvoyé dans la zone à surveiller (22), et un signal de réception est généré à partir de ladite tache lumineuse de réception, et le signal de réception est évalué pour détecter les objets (24),
**caractérisé en ce que**
aussi bien la tache lumineuse d'émission que la tache lumineuse de réception sont réduites au moyen d'un élément de déflexion optique (18), et, avant d'entrer dans l'optique d'émission (20), les faisceaux lumineux individuels (36) sont défléchis les uns vers les autres par l'élément de déflexion optique (18) à l'aide de zones micro-optiques (34) non-imageurs, de sorte que les sections transversales des faisceaux lumineux individuels (36) dans un plan d'image virtuel (42) devant l'optique d'émission (20) occupent conjointement une surface plus petite que celle qui se présente lors de leur génération, de sorte que l'émetteur de lumière (12) se comporte comme un émetteur de lumière avec une disposition plus compacte de sources de lumière individuelles dans le plan d'image virtuel (42), dans lequel les faisceaux lumineux individuels (36) semblent provenir d'une surface plus petite que celle physiquement présente à l'origine sur l'émetteur de lumière (12).
